# EUROPÄISCHE PATENTSCHRIFT

(11) **EP 0 638 212 B1**
(45) Veröffentlichungstag und Bekanntmachung des Hinweises auf die Patenterteilung: **27.03.1996**
(21) Anmeldenummer: 93907800.2
(22) Anmeldetag: 15.04.1993
(51) Int. Cl.: H03H 9/02

(54) **GEWICHTETER REFLEKTOR FÜR EINE OBERFLÄCHENWELLENANORDNUNG**
WEIGHTED REFLECTOR FOR A SURFACE-WAVE DEVICE
REFLECTEUR PONDERE POUR UN DISPOSITIF A ONDES DE SURFACE

(30) Priorität: 27.04.1992 DE 4213800
(43) Veröffentlichungstag der Anmeldung: 15.02.1995
(73) Patentinhaber: SIEMENS AKTIENGESELLSCHAFT, D-80333 München (DE)
(72) Erfinder: RUILE, Werner, D-80636 München (DE); MACHUI, Jürgen, D-80809 München (DE); DILL, Roland, D-81547 München (DE); LEWIS, Brian, Brackley Northants NN13 5HL (GB)
(86) Internationale Anmeldenummer: DE9300335
(87) Internationale Veröffentlichungsnummer: WO9322831

(56) Entgegenhaltungen:
- EP-A- 0 026 114
- EP-A- 0 151 275
- IEEE TRANSACTIONS ON ULTRASONICS FERROELECTRICS AND FREQUENCY CONTROL Bd. 33, Nr. 4, Juli 1986, New York, US pages 369-374 TAKEUCHI new types of SAW reflectors and resonators consisting of reflecting elements with positive and negative reflection coefficients'

## Beschreibung

Die vorliegende Erfindung betrifft einen gewichteten Oberflächenwellenreflektor nach dem Oberbegriff des Patentanspruchs 1 und 2.

Bekannt sind Oberflächenwellenanordnungen, die zu wenigstens einem interdigitalen Wandler auf einem piezoelektrischen Substrat noch wenigstens einen Reflektor für die in diesem Wandler elektrisch erzeugte akustische Welle haben. Diese akustische Welle läuft in der Oberfläche oder im Substrat nahe der Oberfläche dieses Substrates und erfährt in dem Reflektor eine Reflexion, die bei in-line-Anordnungen einer 180° Rückreflexion ist. Ein solcher Reflektor besteht bekanntermaßen aus einer Vielzahl zueinander parallel angeordneter Streifen oder Finger.

In einzelnen Fällen werden Reflektoren verlangt, die sehr schmalbandig sind und hohe Selektivität haben. In erster Linie bestehen solche Reflektoren aus einer sehr großen Anzahl von auf die Mittenfrequenz abgestimmt im Abstand voneinander angeordneten Streifen. Es werden aber auch Oberflächenwellenanordnungen mit Reflektoren mit größerer Bandbreite benötigt. Eine geringere Anzahl von Streifen läßt dies erreichen, jedoch bei geringerem Gesamt-Reflexionsvermögen. Es sind auch Reflektoren mit dispersiver Eigenschaft bekannt.

Im Regelfall ist allen solchen Anordnungen gemeinsam, daß ihre Eigenschaften durch herstellungsbedingte Streuungen gestört bzw. verfälscht sein können, und zwar selbst dann, wenn diese Streuungen, zum Beispiel der Mittenabstände, der vorgegebenen Abmessungen von Breite und Dicke der Streifen und dergleichen, sehr gering sind, nämlich weil Oberflächenwellenelemente sehr hoch-präzise Bauelemente der Elektronik sind.

Oberflächenwellenanordnungen mit Reflektoren weroen zum Beispiel als Resonatoren verwendet. Ein Beispiel eines solchen Resonators ist aus der EP-A-0 257 377 bekannt, wie er in Figur 1 dargestellt ist. Auf beiden Seiten des wenigstens einen Wandlers 6, der sich in der Mitte auf der Oberfläche des Substrats 2 befindet sind je ein Reflektor 3 und 4 gezeigt.

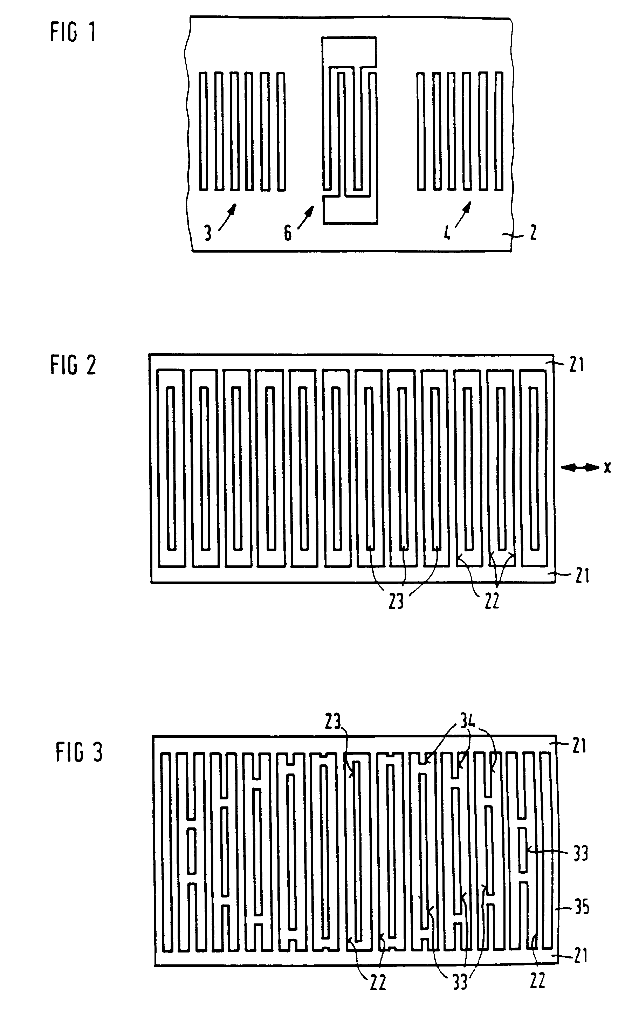

Eine besondere Art eines Reflektors, ein sog. "open-short-Reflektor", ist aus IEEE Trans. on Ultrasonics Ferroelectrics and Frequency Control, Vol. UFFC -33, No. 4 (1966) S. 369 - 374 bekannt. Dieser Reflektor hat Streifen mit einem Mittenabstand der benachbarten Streifen voneinander, der ein Viertel der Wellenlänge der akustischen Welle beträgt. Eine solche Bemessung ist von Splitfinger-Wandlern her geläufig und der Reflektor wird in Anlehnung daran auch als "Splitfinger-Reflektor" bezeichnet. Die einzelnen Streifen (häufig auch als Finger bezeichnet) sind in der Folge ihrer Nebeneinander-Anordnung (in Richtung x der Haupt-Wellenausbreitung) alternierend einerseits durch Sammelschienen miteinander kurzgeschlossene Metallstreifen und andererseits elektrisch "offene" Streifen. Figur 2 zeigt das Grundprinzip eines open-short- Reflektors. Die Sammelschienen sind mit 21 bezeichnet, die die Metallstreifen 22 elektrisch miteinander verbinden. Zwischen den Streifen 22 sind Streifen 23 vorhanden, die gegenüber den Streifen 22 und untereinander elektrisch isoliert sind. Die Anschlußart, offen oder kurzgeschlossen der Streifen 22 und 23 ist wie ersichtlich alternierend.

So wie bei einem Splitfingerwandler löschen sich auch beim open-short-Reflektor der Figur 2 die mechanischen Reflexionen untereinander aus. Die elektrischen Reflexionen dagegen verstärken sich wegen der alternierenden Anschlußfolge der Streifen 22. Diese noch verbleibend auftretende elektrische Reflexion ist im wesentlichen durch den Kopplungsfaktor des Materials des Substrats bestimmt, der eine Materialeigenschaft ist.

Wird ein einen hohen Kopplungsfaktor aufweisendes Substratmaterial wie zum Beispiel Lithiumniobat verwendet, so besitzt ein open-short-Reflektor nach Figur 2 große Reflexionsstärke und ein aus solchen Gruppe aufgebauter Reflektor hat große Bandbreite.

Es ist nicht erforderlich, daß die Breitenabmessungen der Streifen 22 und 23, nämlich die der untereinander kurzgeschlossenen Streifen 22 und die der "offenen" Streifen 23 gleich groß sind. Wichtig ist jedoch die Einhaltung der Lambda-Viertel-Periodizität der Anordnung der Streifen 22 und 23.

Aus der EP-A-0 026 114 ist es weiterhin generell bekannt, Oberflächenwellenreflektoren eine Wichtungsfunktion zu geben.

Aufgabe der vorliegenden Erfindung ist es, einen gewichtete Oberflächenwellenreflektor anzugeben, mit dem eine vorgebbare Übertragungsfunktion realisiert und möglichst weitgehende Unempfindlichkeit gegenüber herstellungsbedingten Toleranzen hinsichtlich der Breite und der Dicke der hierfür erforderlichen Metallstreifen erreicht wird.

Diese Aufgabe wird bei einem Oberflächenwellenreflektor der eingangs genannten Art erfindungsgemäß durch die Merkmale des kennzeichnenden Teils der Patentansprüche 1 und 2 gelöst.

Ein solcher gewichteter Reflektor kann auch Bestandteil eines Oberflächenwandlers sein.

Der vorliegenden Erfindung liegt der Gedanke zugrunde, einen open-short-Reflektor zu verwenden und diesem Reflektor eine Wichtungsfunktion zu geben, die Nullstellen und/ oder sogar Stellen der Phasenumkehr umfassen kann, und zwar dies unabhängig davon, ob diese Wichtungsfunktions stufenlos oder stufenbehaftet ist.

Unter Verwendung einer solchen Oberflächenwellenstruktur läßt sich eine vorgebbare Filterfunktion erfüllen, wobei der open- short-Reflektor der Erfindung gemäß ausgeführt gewichtet ist.

Es ist festgestellt worden, daß ein open-short-Reflektor, wie er oben beschrieben ist, bezüglich seines Reflexionsverhaltens relativ unempfindlich ist gegen Fertigungstoleranzen hinsichtlich der Streifenbreite und der Schichtdicke und daß diese Invarianz auch bei Wichtung eines solchen Reflektors erhalten bleibt.

Ein erfindungsgemäß angewendetes Wichtungsprinzip eines solchen Reflektors ist die Streifen-Weglaßwichtung, bei der überall dort, wo bei dem der vorgegebenen Filterfunktion entsprechenden Design nach keine Reflexion im Reflektor auftreten soll, entweder ein jeweiliger "offener" Streifen der Folge der Streifen 23 mit den Sammelschienen 22 so verbunden wird, daß er nunmehr ein kurzgeschlossener Streifen 22 ist, oder in dem man einen im Reflektor der Figur 2 mit den Sammelschienen kurzgeschlossenen Streifen von diesen Sammelschienen trennt und ihn zu einem "offenen" Streifen macht. In beiden Fällen löschen sich an einem solchen Ort jeweils nicht nur weiterhin die mechanischen Reflexionen, sondern auch noch die elektrischen Reflexionen miteinander aus. Die weitere Erläuterung wird anhand der ersten, hier genannten Variante im einzelnen weiterverfolgt.

Die Erfindung umfaßt als eine Weiterbildung auch die Möglichkeit einer stufenlose Aperturwichtung der Streifen bzw. des Reflektors. Dazu werden lediglich Längenanteile einzelner "offener" Streifen mit den Sammelschienen verbunden und werden damit zu kurzgeschlossenen Streifenanteilen. Figur 3 zeigt ein Prinzipbild einer solchen bei der Erfindung verwendeten Aperturwichtung. Mit 22 sind auch in Figur 3 die kurzgeschlossenen Streifen bezeichnet. Mit 33 sind gewichtete offene Finger des Reflektors der Figur 3 bezeichnet. Wie aus der Figur leicht ersichtlich, haben diese Finger 33 unterschiedliche Länge, nämlich der bekannten Aperturwichtung entsprechend. Es sind aber in Längsrichtung dieser Streifen 33 noch Teilstreifen 34 vorhanden, die von den Streifen 33 abgetrennte und mit den Sammelschienen 21 verbundene Streifenteile sind. Ein Sonderfall sind die beiden endständigen Streifen 35, die sich an einem Ort eines ansonsten offenen Streifens befinden, der aber zu "Null" gewichtet ist und von dem ein nunmehr jeweils gänzlich kurzgeschlossener Streifen übriggeblieben ist. Der in der Anordnung in der Mitte befindliche Streifen 33 ist ein völlig ungewichteter offener Streifen wie er als offener Streifen 23 in der Anordnung der Figur 2 ausschließlich vorhanden ist.

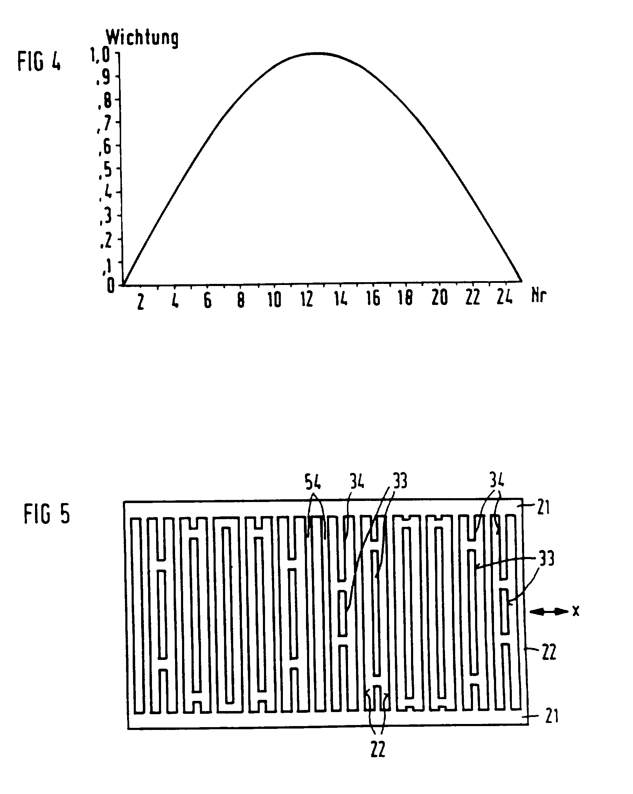

Figur 4 zeigt über der Streifen-"Nummer" auf der Ordinate aufgetragen das Maß des Reflexionsvermögens am Ort eines jeweiligen Streifens des Reflektors nach Figur 3. Es ist dies mit anderen Worten die Wichtungsfunktion. Die Stärke der Reflexion ist nämlich in erster Näherung direkt proportional der "offenen" Länge des jeweiligen offenen Streifens.

Figur 5 zeigt ein Anwendung des Prinzips der Figur 3, jedoch zweifach in diesem Reflektor der Figur 5 enthalten. In ihrer Bedeutung und Funktion mit der Figur 3 übereinstimmende Einzelheiten der Figur 5 sind mit den Bezugszeichen der Figur 3 bezeichnet und haben aucn die zur Figur 3 beschriebene Bedeutung. Besonders zu beachten sind bei der Anordnung der Figur 5 die beiden Streifen 54 in der Mitte des Reflektors. Es sind dies Streifen, die für sich einzeln genommen die Eigenschaften von zu "Null" gewichteten offenen Streifen 34 bzw. 35 der Figur 3 haben. Da die Streifen 54 jedoch mit einem Mittenabstand Lambda-Viertel nebeneinander liegen, ergeben sie einen Vorzeichenwechsel der Reflexion, stellen also einen Phasensprung dar. An der Stelle der Streifen 54 ist die ansonsten alternierende Anordnung von (ungewichteten) kurzgeschlossenen Streifen und von (gewichteten) offenen Streifen (wobei bei letzteren auch zu "Null" gewichtete Streifen der Art der Streifen 35 eingeschlossen sind) unterbrochen.

Die Figur 5 zeigt, daß auch sehr viel kompliziertere (stufenlose) Wichtungsfunktionen mit der Erfindung realisierbar sind.

Die Figur 6 zeigt, daß auch eine beliebige Plazierung der offenen Streifen in der zur Verfügung stehenden Apertur möglich ist. Die Anordnung der Figur 6 entspricht im wesentlichen der der Figur 3, jedoch sind, wie ersichtlich, die Schwerpunkte der elektrischen Reflexion über den Reflektor in Querrichtung zum Reflektor, das heißt in Richtung der Vertikalen in Figur 6, verschoben.

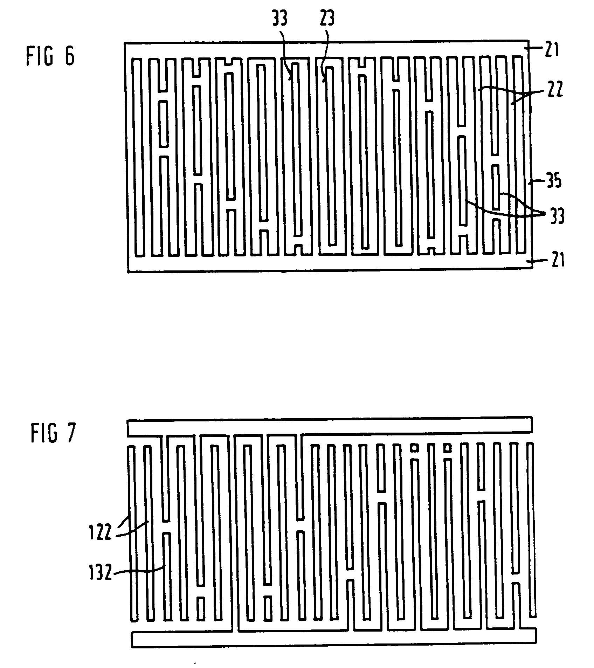

Eine noch weitere Ausgestaltung der Erfindung besteht darin, daß die offenen Streifen auch mehrfach untereinander unterbrochen sein können, wie dies zum Beispiel in der EP-A-0 124 019 im anderen Zusammenhang bereits beschrieben ist. Mit dieser Maßnahme lassen sich Multistripkoppler-Effekte vermeiden. Es können zu diesem Zwecke (zusätzlich) auch die kurzgeschlossenen Streifen 22, jeder aber nur einmal, unterbrochen sein, soweit die Sammelschienen 21 (ohnehin zweckmäßigerweise) miteinander verbunden sind. Figur 6 zeigt zusätzlich solche Unterbrechungen.

Verzichtet man auf wie voranstehend beschriebene Unterbrechung auch der kurzgeschlossenen Streifen, genügt es, nur eine der bei den dargestellten Ausführungen vorgesehenen Sammelschienen 21 vorzusehen, da dann bereits eine der Sammelschienen das Miteinanderkurzschließen der Streifen 22 sicherstellt.

Im Patentanspruch 1 sind "Paare" jeweils zweier Reflektorstreifen definiert, von denen im bekannten open-short-Reflektor der eine Metallisierungsstreifen ein kurzgeschlossener (short) Streifen und der andere Streifen ein offener (open) Streifen ist. Letzterer kann in der Oberflächenwellenstruktur beliebiges floatendes Potential annehmen, wo hingegen der kurzgeschlossene Streifen stets das Potential der Sammelschiene hat, mit der dieser Streifen elektrisch verbunden ist. Im Kennzeichen des Anspruchs 1 ist ebenfalls von "Paaren" die Rede, jedoch sind diese Paare nicht notwendigerweise identisch mit den "Paaren" des Oberbegriffs. D.h. daß von einem Paar Streifen des Oberbegriffs der eine Streifen einem ersten Paar Streifen des Kennzeichens zugehört und der andere Streifen zu einem zweiten, benachbarten Paar Streifen des Kennzeichens zugerechnet ist. Der Anspruch 1 umfaßt damit eine Vielzahl von Ausführungsmöglichkeiten, bei denen ein kurzgeschlossener Streifen a und ein benachbarter offener Streifen b erfindungsgemäß wie folgt verändert sein können:
1. Der Streifen a bleibt ein kurzgeschlossener Streifen und der Streifen b wird zu einem Streifen, der zu einem Längenanteil ein offener Streifen bleibt und von dem übrige Längenanteile mit der einen oder den beiden Sammelschienen kurzgeschlossen werden. Dieser Streifen b ist damit ein längengewichteter offener Streifen.
2. Ein Sonderfall des Falles 1 ist, daß der Streifen b mit seiner gesamten Länge zu einem kurzgeschlossenen, zu "Null" gewichteten Streifen gemacht wird, konstruktiv also von einem Streifen a nicht zu unterscheiden ist.
3. Der Streifen b bleibt ein unveränderter offener Streifen und der Streifen a wird so unterteilt, so daß ein Längenanteil dieses Streifens a zu einem offenen Streifen wird. Bei zweiseitig vorhandenen Sammelschienen 21 erfordert dies wenigstens zwei Unterbrechungen.
4. Ein Sonderfall des Falles 3 ist, daß der Streifen a mit seiner ganzen Längen abgeteilt wird, d.h. zu einem (zu "Null" gewichteten Streifen der Art eines Streifens b wird.

Ein Phasensprung (siehe Figur 5 die Streifen 54) stellt sich dabei so dar, als ob in die Struktur ein kurzgeschlossener Finger des Typs a zusätzlich eingefügt ist. An einer Stelle des Phasensprunges hat also die Struktur zwei benachbarte kurzgeschlossene Streifen (des Typs a). Stattdessen kann auch ein zusätzlicher Streifen b eingefügt sein mit bzw. als Phasensprung der Periodizität.

Mit den Figuren 3, 5 und 6 sind Beispiele gezeigt, die die kurzgeschlossenen und die offenen Metallisierungsstreifen des gewichteten Reflektors verteilt und die offenen Finger längengewichtet sind. Dieselbe Übertragungsfunktion realisiert der dazu inverse Reflektor, bei dem - wie dies die Figur 7 im Vergleich zur 5 zeigt - alle kurzgeschlossenen Streifen mit allen offenen, gegebenenfalls gewichteten Streifen vertauscht sind. Die beiden von links ersten (kurzgeschlossenen) Streifen des Reflektors der Figur 5 sind im Reflektor der Figur 7 offene Streifen 122, und zwar ungewichtet. Der von links dritte Streifen der Figur 5, der dort ein gewichteter offener Streifen ist, ist bei dem Reflektor der Figur 7 ein kurzgeschlossener, jedoch durch einen offenen Längenanteil 132 gewichteter Streifen. Bei der inversen Struktur sind die offenen Finger ungewichtet und die Wichtung ist an den Metallisierungsstreifen ausgeführt, die in der Struktur nach Figur 5 die Kurzgeschlossenen Streifen sind. Diese gewichteten Metallisierungsstreifen haben dann, der Wichtung entsprechend offene (mit keiner Sammelschiene verbundene) Längenanteile, die zusätzlich (zur Vermeidung von Splitfingereffekten) auch noch weiterhin unterbrochen sein können. Aus diesem Grunde können auch die bei einem solchen "inversen" Reflektor vorhandenen ungewichteten offenen Streifen zusätzliche Unterbrechungen haben.

## Patentansprüche

1. Gewichteter Oberflachenwellenreflektor mit parallel zueinander angeordneten Metallisierungsstreifen (22, 23, 33, 34, 35; 22, 33, 34, 35; 22, 23, 33, 35; 122, 132) und wenigstens einer Sammelschiene (21), wobei über die Sammelschiene (21) verbundene Metallisierungsstreifen (22, 34, 35; 22, 34, 54; 22, 35) und offene Metallisierungsstreifen (33; 122, 132) vorgesehen sind,
**dadurch gekennzeichnet**, daß
die offenen Metallisierungsstreifen gemäß einer vorgegebenen Wichtungsfunktion in ihrer Länge variieren und in den Freiräumen zwischen offenen Metallisierungsstreifen und Sammelschiene(n) an die Sammelschiene(n) angeschlossene Metallisierungsstreifen angeordnet sind.

2. Gewichteter Oberflächenwellenreflektor mit parallel zueinander angeordneten Metallisierungsstreifen (22, 23, 33, 34, 35; 22, 33, 34, 35; 22, 23, 33, 35; 122, 132) und zwei Sammelschienen (21), wobei über die Sammelschienen (21) verbunden Metallisierungsstreifen (22, 34, 35; 22, 34, 54; 22, 35) und offene Metallisierungsstreifen (33; 122, 132) vorgesehen sind,
**dadurch gekennzeichnet**,
daß die angeschlossenen Metallisierungsstreifen in ihrer Längsrichtung unterbrochen sind, daß die Länge der Unterbrechung durch eine vorgegebene Wichtungsfunktion bestimmt wird, und daß in den Unterbrechungen ein isolierter Metallisierungsstreifen vorgesehen ist.

## Claims

1. Weighted surface-wave reflector having metallization strips (22, 23, 33, 34, 35; 22, 33, 34, 35; 22, 23, 33, 35; 122, 132) which are arranged parallel to one another and at least one busbar (21), metallization strips (22, 34, 35; 22, 34, 54; 22, 35) which are connected via the busbar (21) and open metallization strips (33; 122, 132) being provided, characterized in that the open metallization strips vary in their length in accordance with a predetermined weighting function, and metallization strips which are connected to the busbar or busbars are arranged in the free spaces between open metallization strips and the busbar or busbars.

2. Weighted surface-wave reflector having metallization strips (22, 23, 33, 34, 35; 22, 33, 34, 35; 22, 23, 33, 35; 122, 132) which are arranged parallel to one another and two busbars (21), metallization strips (22, 34, 35; 22, 34, 54; 22, 35) which are connected via the busbars (21) and open metallization strips (33; 122, 132) being provided, characterized in that the connected metallization strips are interrupted in their longitudinal direction, in that the length of the interruption is determined by a predetermined weighting function, and in that an insulated metallization strip is provided in the interruptions.

## Revendications

1. Réflecteur pondéré à ondes de surface, comportant des bandes (22, 23, 33, 34, 35 ; 22, 33, 34, 35 ; 22, 23, 33, 35 ; 122, 132) de métallisation disposées parallèlement les unes aux autres et au moins un rail (21) collecteur, des bandes de métallisation (22, 34, 35 ; 22, 34, 54 ; 22, 35) reliées par le rail (21) collecteur et des bandes de métallisation (33 ; 122, 132) ouvertes étant prévues,
caractérisé en ce que
la longueur des bandes de métallisation ouvertes varie suivant une fonction de pondération prescrite et des bandes de métallisation connectées au(x) rail(s) collecteur(s) sont disposées dans les espaces libres entre des bandes de métallisation ouvertes et un ou des rails collecteurs.

2. Réflecteur pondéré à ondes de surface comportant des bandes (22, 23, 33, 34, 35 ; 22, 33, 34, 35 ; 22, 23, 33, 35 ; 122, 132) de métallisation disposées parallèlement les unes aux autres et deux rails (21) collecteurs, les bandes (22, 34, 35 ; 22, 34, 54 ; 22, 35) de métallisation reliées par les rails (21) collecteurs et des bandes (33; 122, 132) de métallisation ouvertes étant prévues,
caractérisé en ce que
les bandes de métallisation connectées sont interrompues dans le sens de la longueur, la longueur de l'interruption est déterminée par une fonction de pondération prescrite et une bande de métallisation isolée est prévue dans les interruptions.
